(19) Europäisches Patentamt
European Patent Office
Office européen des brevets

(11) **EP 3 326 231 B1**

(12) **EUROPÄISCHE PATENTSCHRIFT**

(45) Veröffentlichungstag und Bekanntmachung des Hinweises auf die Patenterteilung:
**25.11.2020   Patentblatt 2020/48**

(21) Anmeldenummer: **16736836.4**

(22) Anmeldetag: **06.07.2016**

(51) Int Cl.:
*H01M 10/42 (2006.01)*  *H01M 10/44 (2006.01)*
*H01M 10/48 (2006.01)*  *G01R 1/20 (2006.01)*
*G01R 31/396 (2019.01)*

(86) Internationale Anmeldenummer:
**PCT/EP2016/065912**

(87) Internationale Veröffentlichungsnummer:
**WO 2017/012865 (26.01.2017 Gazette 2017/04)**

(54) **ZELLEINHEIT UND VERFAHREN ZUR BESTIMMUNG EINES DURCH EINE ZELLEINHEIT FLIESSENDEN STROMS**

CELL UNIT, AND METHOD FOR DETERMINING A CURRENT FLOWING THROUGH A CELL UNIT

UNITÉ DE CELLULE ET PROCÉDÉ DE DÉTERMINATION D'UN COURANT S'ÉCOULANT À TRAVERS UNE UNITÉ DE CELLULE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.07.2015   DE 102015213456**

(43) Veröffentlichungstag der Anmeldung:
**30.05.2018   Patentblatt 2018/22**

(73) Patentinhaber: **Robert Bosch GmbH**
**70442 Stuttgart (DE)**

(72) Erfinder:
• **FRIEDRICH, Marco**
**71638 Ludwigsburg (DE)**
• **BUTZMANN, Stefan**
**58579 Schalksmühle (DE)**
• **BERNHARDT, Christian**
**70327 Stuttgart (DE)**
• **HILLENBRAND, Philipp**
**72639 Neuffen (DE)**

(56) Entgegenhaltungen:
**EP-A1- 2 669 988       WO-A1-2012/123815**
**DE-A1-102012 214 956**

EP 3 326 231 B1

## Beschreibung

Die Erfindung betrifft eine Zelleinheit, welche mindestens eine Batteriezelle umfasst. Die Erfindung betrifft auch ein Verfahren zur Bestimmung eines Stroms, der durch eine erfindungsgemäße Zelleinheit fließt.

Stand der Technik

Elektrische Energie ist mittels Batterien speicherbar. Batterien wandeln chemische Reaktionsenergie in elektrische Energie um. Hierbei werden Primärbatterien und Sekundärbatterien unterschieden. Primärbatterien sind nur einmal funktionsfähig, während Sekundärbatterien, die auch als Akkumulator bezeichnet werden, wieder aufladbar sind. Eine Batterie umfasst dabei eine oder mehrere Batteriezellen.

In einem Akkumulator finden insbesondere sogenannte Lithium-Ionen-Batteriezellen Verwendung. Diese zeichnen sich unter anderem durch hohe Energiedichten aus. Lithium-Ionen-Batteriezellen kommen unter anderem in Kraftfahrzeugen, insbesondere in Elektrofahrzeugen (Electric Vehicle, EV), Hybridfahrzeugen (Hybride Electric Vehicle, HEV) sowie Plug-In-Hybridfahrzeugen (Plug-In-Hybride Electric Vehicle, PHEV) zum Einsatz.

Lithium-Ionen-Batteriezellen weisen eine positive Elektrode, die auch als Kathode bezeichnet wird, und eine negative Elektrode, die auch als Anode bezeichnet wird, auf. Die Anode und die Katode sind durch einen Separator voneinander getrennt. Die Elektroden und der Separator sind von einem in der Regel flüssigen Elektrolyt umgeben. Die beiden Elektroden sind mittels Kollektoren elektrisch mit Polen der Batteriezelle, welche auch als Terminals bezeichnet werden, verbunden.

Aus der WO 2014/086696 A2 sind Speichermodule bekannt, welche seriell in einem Versorgungsstrang verschaltet sind. Jedes Speichermodul umfasst dabei eine Batteriezelle, zwei Anschlüsse, sowie mindestens zwei Schaltelemente. Die Schaltelemente sind derart angeordnet und ansteuerbar, dass die Batteriezelle zwischen die Anschüsse geschaltet wird oder dass die Batteriezelle überbrückt wird.

Ähnliche Module sind auch aus den Druckschriften DE 10 2010 027 857 A1 und DE 10 2010 027 861 A1 bekannt.

Für verschiedene Anwendungen ist eine Kenntnis des durch eine Batteriezelle, beziehungsweise durch eine Zelleinheit fließenden Stroms erforderlich oder vorteilhaft. Hierzu sind im Stand der Technik mehrere Verfahren bekannt, beispielsweise mittels Shunt-Widerständen oder Hall-Sensoren.

Aus der US 2008/0278116 A1 ist es bekannt, einen durch eine Batterie fließenden Strom mittels einer an einem Halbleiterbauelement abfallenden Spannung zu bestimmen.

Ein ähnliches Verfahren zur Bestimmung eines durch eine Batterie fließenden Stroms mittels einer an einem Halbleiterbauelement abfallenden Spannung ist aus der JP 2001-339869 bekannt.

WO 2012/123895 A1 bezieht sich auf eine Schalteinrichtung, über welche eine Anzahl von Batteriezellen miteinander verbunden wird.

EP 2 669 988 A1 hat einen Batteriepack sowie eine Leistung verbrauchende Einrichtung zum Gegenstand. Eine Anzahl von Sekundärbatteriezellen ist zum Zeitpunkt des Entladens in Serie geschaltet und wird zum Zeitpunkt des Ladens in Parallelschaltung überführt.

DE 10 2012 214 956 A1 hat eine Halbbrückenschaltung zum Gegenstand, welche mindestens zwei Schaltmittel umfasst, welche dazu ausgebildet sind, mindestens eine Batteriezelle per Ansteuerung zu einem Batteriestrang hinzuzuschalten oder von diesem zu entkoppeln.

Offenbarung der Erfindung

Es wird eine Zelleinheit gemäß Anspruch 1 vorgeschlagen.

Diese Anordnung der Schaltelemente und der Batteriezelle gestattet, durch Ansteuern der Schaltelemente die Batteriezelle zwischen den ersten Anschluss und den zweiten Anschluss zu schalten, oder die Batteriezelle in der Zelleinheit zu überbrücken. Bei den Schaltelementen handelt es sich um Feldeffekttransistoren.

Erfindungsgemäß ist ein dritter Anschluss vorgesehen, welcher mit dem ersten Schaltelement und mit der Batteriezelle verbunden ist. Das erste Schaltelement ist somit elektrisch zwischen dem ersten Anschluss und dem dritten Anschluss der Zelleinheit angeordnet.

Durch den dritten Anschluss ist eine Spannungsmessung an dem ersten Schaltelement möglich. Die an dem ersten Schaltelement anliegende Spannung entspricht der zwischen dem ersten Anschluss und dem dritten Anschluss der Zelleinheit anliegenden Spannung. Durch Messung der an dem geschlossenen ersten Schaltelement anliegenden Spannung, welche als erste Spannung bezeichnet wird, und bei Kenntnis des Widerstands des geschlossenen ersten Schaltelements ist somit ein durch das geschlossene erste Schaltelement fließender Strom bestimmbar. Der durch das geschlossene erste Schaltelement fließende Strom entspricht dem durch die Batteriezelle fließenden Strom.

Die an dem zweiten Schaltelement anliegende Spannung entspricht der zwischen dem ersten Anschluss und dem zweiten Anschluss der Zelleinheit anliegenden Spannung. Durch Messung der an dem geschlossenen zweiten Schaltelement anliegenden Spannung, welche als zweite Spannung bezeichnet wird, und bei Kenntnis des Widerstands des geschlossenen zweiten Schaltelements ist somit ein durch das geschlossene zweite Schaltelement fließender Strom bestimmbar. Der durch das geschlossene zweite Schaltelement fließende Strom entspricht dabei dem parallel zu der Batteriezelle fließenden Strom.

Erfindungsgemäß sind daher Mittel zur Messung der ersten Spannung zwischen dem ersten Anschluss und dem dritten Anschluss der Zelleinheit vorgesehen. Ferner Mittel zur Messung einer zweiten Spannung zwischen dem ersten Anschluss und dem zweiten Anschluss der Zelleinheit vorgesehen.

Gemäß einer vorteilhaften Weiterbildung der Erfindung ist eine Recheneinheit vorgesehen, welche dazu eingerichtet ist, einen durch die Zelleinheit fließenden Strom aus der gemessenen Spannung und einem elektrischen Widerstand des geschlossenen Schaltelements zu bestimmen.

Aus der gemessenen ersten Spannung und einem ersten elektrischen Widerstand des geschlossenen ersten Schaltelements ist der durch die Batteriezelle fließende Strom bestimmbar. Aus der gemessenen zweiten Spannung und einem zweiten elektrischen Widerstand des geschlossenen zweiten Schaltelements ist der parallel zu der Batteriezelle fließende Strom bestimmbar. Je nach Stellung der Schaltelemente entspricht der durch die Zelleinheit fließende Strom dem durch die Batteriezelle fließenden Strom oder dem parallel zu der Batteriezelle fließenden Strom.

Gemäß einer vorteilhaften Ausgestaltung der Erfindung umfasst die Recheneinheit auch ein Modell zur Bestimmung des elektrischen Widerstands des geschlossenen Schaltelements, insbesondere unter Berücksichtigung einer an dem Schaltelement anliegenden Steuerspannung und/oder einer Temperatur des Schaltelements und/oder weiterer physikalischer Parameter des Schaltelements.

Wenn es sich bei den Schaltelementen beispielsweise um Feldeffekttransistoren handelt, so ist der elektrische Widerstand des geschlossenen Schaltelements nicht konstant, sondern von mehreren Faktoren, insbesondere von der anliegenden Steuerspannung und von der Temperatur des Schaltelements, abhängig.

Es wird auch ein Verfahren zur Bestimmung eines durch eine erfindungsgemäße Zelleinheit fließenden Stromes vorgeschlagen. Dabei wird eine über einem geschlossenen Schaltelement der Zelleinheit abfallende Spannung gemessen, und der Strom wird aus der gemessenen Spannung und einem elektrischen Widerstand des geschlossenen Schaltelements bestimmt. Der Strom ergibt sich dabei als Quotient aus der gemessenen Spannung und dem elektrischen Widerstand des geschlossenen Schaltelements. Der durch das geschlossene Schaltelement fließende Strom entspricht dabei dem durch die Zelleinheit fließenden Strom.

Insbesondere, wenn es sich bei den Schaltelementen um Feldeffekttransistoren handelt, wird der elektrische Widerstand des geschlossenen Schaltelements vorteilhaft unter Berücksichtigung einer an dem Schaltelement anliegenden Steuerspannung sowie einer Temperatur des Schaltelements und/oder weiterer physikalischer Parameter des Schaltelements bestimmt. Bei Feldeffekttransistoren ist der elektrische Widerstand des geschlossenen Schaltelements nicht konstant, sondern von mehreren Faktoren, insbesondere von der anliegenden Steuerspannung und von der Temperatur des Schaltelements, abhängig.

Daher werden der elektrische Widerstand des geschlossenen Schaltelements und der Strom vorteilhaft in einer Recheneinheit bestimmt, welche ein Modell zur Bestimmung des elektrischen Widerstands des geschlossenen Schaltelements umfasst. Das Modell kann dabei neben der anliegenden Steuerspannung und der Temperatur des Schaltelements auch noch andere Faktoren zur Bestimmung des elektrischen Widerstands des geschlossenen Schaltelements berücksichtigen.

Vorzugsweise wird ein analoger Wert der gemessenen Spannung in einen digitalen Wert gewandelt, welcher dann zu der Recheneinheit übertragen wird. Aber auch eine Übertragung des analogen Werts der gemessenen Spannung zu der Recheneinheit ist denkbar.

Vorteilhaft findet auch eine Kalibrierung der Recheneinheit statt. Zur Kalibrierung der Recheneinheit wird ein Kalibrierstrom durch die Zelleinheit geleitet. Dabei werden der elektrische Widerstand des geschlossenen Schaltelements und der durch das geschlossene Schaltelement fließende Strom in der Recheneinheit bestimmt. Der von der Recheneinheit bestimmte Strom wird dann mit dem Kalibrierstrom verglichen. Bei einer Abweichung des bestimmten Stroms von dem Kalibrierstrom wird das Modell zur Bestimmung des elektrischen Widerstands des geschlossenen Schaltelements korrigiert. Gegebenenfalls wird die Kalibrierung in mehreren Iterationen durchgeführt. Dabei werden die Schritte zur Kalibrierung der Recheneinheit so lange wiederholt, bis keine signifikante Abweichung des von der Recheneinheit bestimmten Stroms von dem Kalibrierstrom mehr messbar ist.

Vorzugsweise ist der Kalibrierstrom ein Ladestrom der Zelleinheit. Die Größe des Ladestroms der Zelleinheit kann beispielsweise durch Messeinrichtungen im Batteriesystem oder durch Messeinrichtungen in der Ladeeinrichtung bestimmt werden und über Kommunikationseinrichtungen in der Recheneinheit bereitgestellt werden. Die Größe des Ladestroms der Zelleinheit ist somit bekannt und kann somit von der Recheneinheit verarbeitet werden.

Wenn die Batteriezelle zwischen den ersten Anschluss und den zweiten Anschluss geschaltet ist, entspricht der durch die Zelleinheit fließende Strom dem durch die Batteriezelle fließenden Strom, also dem durch das erste Schaltelement fließenden Strom. Wenn die Batteriezelle in der Zelleinheit überbrückt ist, entspricht der durch die Zelleinheit fließende Strom dem parallel zu der Batteriezelle fließenden Strom, also dem durch das zweite Schaltelement fließenden Strom. Durch entsprechendes Ansteuern der Schaltelemente kann somit eine Kalibrierung für beide Schaltelemente durchgeführt werden.

Über eine Änderung des elektrischen Widerstands des Schaltelements kann eine Alterung des Schaltelements überwacht werden. Bei Erkennung eines drohenden Frühausfalls des Schaltelements können dann Sicherheitsmaßnahmen eingeleitet werden, insbesondere ein Abschalten der Batteriezelle und/oder ein Abschalten eines dem Schaltelement zugeordneten Batteriemoduls und/oder Batteriesystems und/oder ein Austausch des Schaltelements.

Eine erfindungsgemäße Zelleinheit sowie das erfindungsgemäße Verfahren finden vorteilhaft Verwendung in einem Elektrofahrzeug (EV), in einem Hybridfahrzeug (HEV), in einem Plug-In-Hybridfahrzeug (PHEV), oder in einem Consumer-Elektronik-Produkt. Unter Consumer-Elektronik-Produkten sind insbesondere Mobiltelefone, Tablet-PCs oder Notebooks zu verstehen. Weitere Beispiele für Anwendungsfälle beinhalten Energieversorgungseinrichtungen wie Solaranlagen oder stationäre Energiespeichereinrichtungen.

Vorteile der Erfindung

Durch die erfindungsgemäße Ausgestaltung der Zelleinheit sowie durch das erfindungsgemäße Verfahren zur Bestimmung des durch die Zelleinheit fließenden Stromes ist eine verhältnismäßig einfache Strommessung möglich. Insbesondere sind keine zusätzlichen Mittel, wie beispielsweise Shunt-Widerstände oder Hall-Sensoren erforderlich.

Mittels der Kalibrierung sind auch Streuungen in den Bauteilen, insbesondere, wenn Feldeffekttransistoren oder andere Halbleiterschalter als Schaltelemente eingesetzt werden, ausgleichbar. Ebenso kann der Einfluss alterungsbedingter Veränderungen der Bauteile auf das Messverfahren ausgeglichen werden. Die Kalibrierung kann während des regulären Betriebs der Zelleinheit durchgeführt werden. Eine Benutzung eines externen Kalibriergeräts ist nicht erforderlich. Ebenso ist keine besondere Wartung mit entsprechendem Zeitaufwand zur Kalibrierung erforderlich.

Mit dem oben dargestellten Kalibrierverfahren ist es darüber hinaus möglich, langfristige Veränderungen des Schalters zu überwachen und drohende Ausfälle des Schalters somit frühzeitig zu erkennen. Bei wiederholter Kalibrierung ist bekannt, wie sich der Widerstand R des Schalters im Laufe der Lebensdauer verändert. Dadurch kann auf die Geschwindigkeit der Alterung des Bauteils geschlossen werden, drohende Ausfälle des Halbleiterschalters können frühzeitig erkannt werden, und es können bei drohendem Ausfall des Bauteils Gegenmaßnahmen auf Systemebene eingeleitet werden, z.B. permanenter Bypass der Batteriezelle oder Reparatur des Batteriesystems.

Kurze Beschreibung der Zeichnungen

Ausführungsformen der Erfindung werden anhand der Zeichnungen und der nachfolgenden Beschreibung näher erläutert.

Es zeigen:

Figur 1    eine schematische Darstellung einer Batteriezelle,

Figur 2    eine schematische Darstellung einer Zelleinheit mit einer Batteriezelle aus Figur 1 und

Figur 3    eine schematische Darstellung eines Versorgungsstrangs mit mehreren Zelleinheiten aus Figur 2.

Ausführungsformen der Erfindung

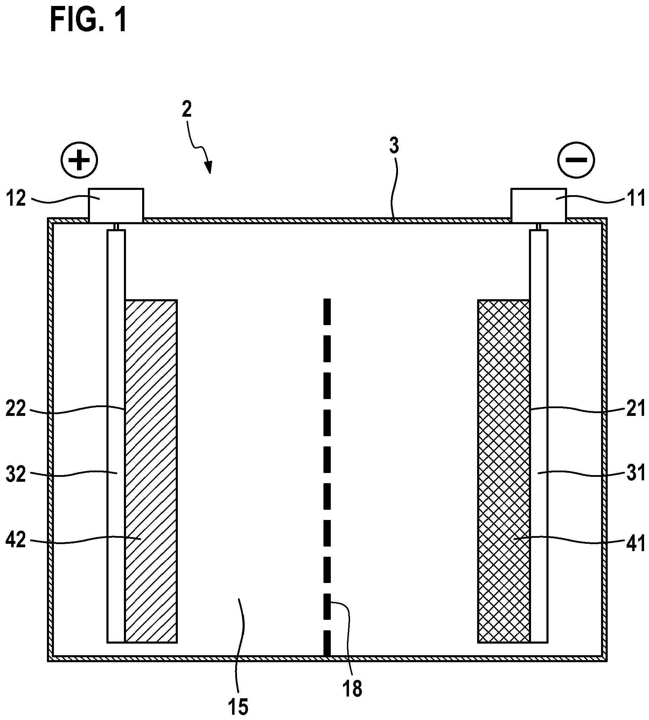

Eine Batteriezelle 2 ist in Figur 1 schematisch dargestellt. Die Batteriezelle 2 umfasst ein Zellengehäuse 3, welches prismatisch, vorliegend quaderförmig, ausgebildet ist. Das Zellengehäuse 3 ist vorliegend elektrisch leitend ausgeführt und beispielsweise aus Aluminium gefertigt. Das Zellengehäuse 3 kann aber auch aus einem elektrisch isolierenden Material, beispielsweise Kunststoff, gefertigt sein. Ebenso sind andere Zellformen bekannt, beispielsweise Rundzellen, Pouchzellen, spezielle Bauformen, auf die die Erfindung gleichermaßen Anwendung finden kann.

Die Batteriezelle 2 umfasst ein negatives Terminal 11 und ein positives Terminal 12. Über die Terminals 11, 12 kann eine von der Batteriezelle 2 zur Verfügung gestellte Spannung abgegriffen werden. Ferner kann die Batteriezelle 2 über die Terminals 11, 12 auch geladen werden. Die Terminals 11, 12 sind beabstandet voneinander an einer Deckfläche des Zellengehäuses 3 angeordnet. Ebenso kann eines der Terminals 11, 12 oder mehrere Terminals 11, 12 direkt durch eine elektrisch leitfähige Fläche des Zellengehäuses 3 gebildet sein.

Innerhalb des Zellengehäuses 3 der Batteriezelle 2 ist ein Elektrodenwickel angeordnet, welcher zwei Elektroden, nämlich eine Anode 21 und eine Kathode 22, aufweist. Die Anode 21 und die Kathode 22 sind jeweils folienartig ausgeführt und unter Zwischenlage eines Separators 18 zu dem Elektrodenwickel gewickelt. Es ist auch denkbar, dass mehrere Elektrodenwickel in dem Zellengehäuse 3 vorgesehen sind. Anstelle des Elektrodenwickels kann auch beispielsweise ein Elektrodenstapel vorgesehen sein.

Die Anode 21 umfasst ein anodisches Aktivmaterial 41, welches folienartig ausgeführt ist. Die Anode 21 umfasst ferner einen Stromableiter 31. Das anodische Aktivmaterial 41 und der Stromableiter 31 der Anode 21 sind elektrisch miteinander verbunden.

Der Stromableiter 31 der Anode 21 ist elektrisch leitfähig ausgeführt und beispielsweise aus Kupfer gefertigt. Der Stromableiter 31 der Anode 21 ist elektrisch mit dem negativen Terminal 11 der Batteriezelle 2 verbunden.

Die Kathode 22 umfasst ein kathodisches Aktivmaterial 42, welches folienartig ausgeführt ist. Die Kathode 22 umfasst ferner einen Stromableiter 32. Das kathodische Aktivmaterial 42 und der Stromableiter 32 der Kathode 22 sind elektrisch miteinander verbunden.

Der Stromableiter 32 der Kathode 22 ist elektrisch leitfähig ausgeführt und beispielsweise aus Aluminium gefertigt. Der Stromableiter 32 der Kathode 22 ist elektrisch mit dem positiven Terminal 12 der Batteriezelle 2 verbunden.

Die Anode 21 und die Kathode 22 sind durch den Separator 18 voneinander getrennt. Der Separator 18 ist ebenfalls folienartig ausgebildet. Der Separator 18 ist elektrisch isolierend ausgebildet, aber ionisch leitfähig, also für Lithiumionen durchlässig.

Das Zellengehäuse 3 der Batteriezelle 2 ist mit einem Elektrolyt 15, beispielsweise mit einem flüssigen Elektrolyt oder mit einem Polymerelektrolyt, gefüllt. Der Elektrolyt 15 umgibt dabei die Anode 21, die Kathode 22 und den Separator 18. Auch der Elektrolyt 15 ist ionisch leitfähig.

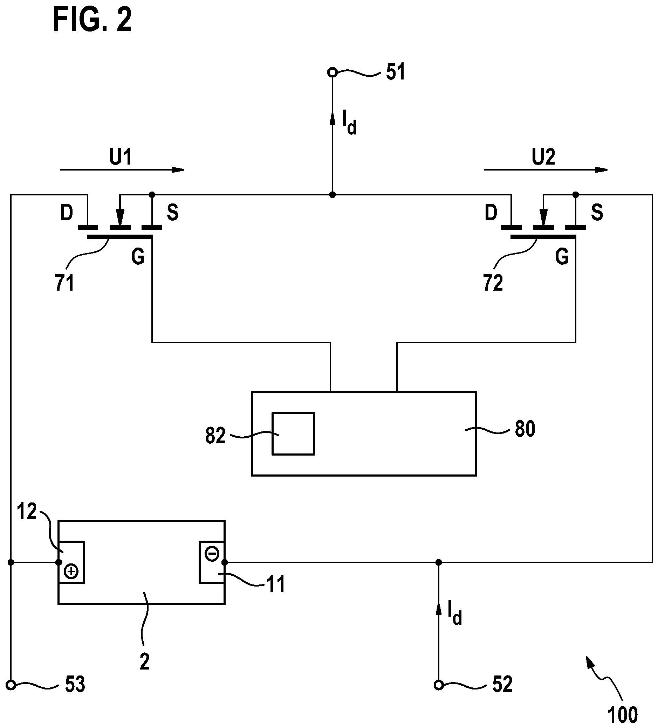

In Figur 2 ist eine Zelleinheit 100 schematisch dargestellt. Die Zelleinheit 100 umfasst eine in Figur 1 gezeigte Batteriezelle 2 sowie eine erstes Schaltelement 71 und ein zweites Schaltelement 72. Das erste Schaltelement 71 ist in Serie zu der Batteriezelle 2 geschaltet. Das zweite Schaltelement 72 ist parallel zu der Serienschaltung aus erstem Schaltelement 71 und Batteriezelle 2 geschaltet. Anstatt einer einzelnen Batteriezelle 2 kann die Zelleinheit 100 auch mehrere Batteriezellen 2 umfassen, welche vorzugsweise in Serie geschaltet sind.

Die Zelleinheit 100 umfasst einen ersten Anschluss 51, einen zweiten Anschluss 52 und einen dritten Anschluss 53. Der erste Anschluss 51 ist mit dem ersten Schaltelement 71 und mit dem zweiten Schaltelement 72 verbunden. Der zweite Anschluss 52 ist mit der Batteriezelle 2 und mit dem zweiten Schaltelement 72 verbunden. Der dritte Anschluss 53 ist mit dem ersten Schaltelement 71 und mit der Batteriezelle 2 verbunden.

Bei den Schaltelementen 71, 72 handelt es sich vorliegend um selbstsperrende n-Kanal-Feldeffekttransistoren (Anreicherungstyp), welche jeweils ein Gate G, einen Drain D und eine Source S aufweisen. Bei Anlegen einer Steuerspannung zwischen Gate G und Source S sinkt der Widerstand zwischen Source S und Drain D, wodurch das Schaltelement 71, 72 geschlossen wird. Es sind aber auch andere Arten von Schaltelementen denkbar, insbesondere andere Feldeffekttransistoren.

Vorliegend ist der erste Anschluss 51 mit der Source S des ersten Schaltelements 71 und mit dem Drain D des zweiten Schaltelements 72 verbunden. Der zweite Anschluss 52 ist mit dem negativen Terminal 11 der Batteriezelle 2 und mit der Source S des zweiten Schaltelements 72 verbunden. Der dritte Anschluss 53 ist mit dem Drain D des ersten Schaltelements 71 und mit dem positiven Terminal 12 der Batteriezelle 2 verbunden.

Die Schaltelemente 71, 72 sind durch Anlegen einer entsprechenden Steuerspannung ansteuerbar. Wenn das erste Schaltelement 71 geschlossen und das zweite Schaltelement 72 geöffnet ist, so ist die Batteriezelle 2 zwischen den ersten Anschluss 51 und den zweiten Anschluss 52 geschaltet. Wenn das zweite Schaltelement 72 geschlossen und das erste Schaltelement 71 geöffnet ist, so ist die Batteriezelle 2 in der Zelleinheit 100 überbrückt.

Die Zelleinheit 100 umfasst ferner hier nicht dargestellte Mittel zur Messung einer ersten Spannung U1 zwischen dem ersten Anschluss 51 und dem dritten Anschluss 53, sowie zur Messung einer zweiten Spannung U2 zwischen dem ersten Anschluss 51 und dem zweiten Anschluss 52. Die erste Spannung U1 entspricht dabei der zwischen Drain D und Source S des ersten Schaltelements 71 anliegenden Spannung. Die zweite Spannung U2 entspricht dabei der zwischen Drain D und Source S des zweiten Schaltelements 72 anliegenden Spannung.

Die Zelleinheit 100 weist auch eine Recheneinheit 80 auf. Die Recheneinheit 80 dient einerseits zur Ansteuerung der Schaltelemente 71, 72 mittels einer Steuerspannung und ist daher jeweils mit den Gates G der Schaltelemente 71, 72 verbunden.

Die Recheneinheit 80 dient auch zur Bestimmung eines durch die Zelleinheit 100, von dem zweiten Anschluss 52 zu dem ersten Anschluss 51, fließenden Stroms Id. Dazu umfasst die Recheneinheit 80 ein mathematisches Modell 82 zur Bestimmung eines ersten Widerstandes R1 des geschlossenen ersten Schaltelements 71 sowie zur Bestimmung eines zweiten Widerstandes R2 des geschlossenen zweiten Schaltelements 72.

Der erste Widerstand R1 des geschlossenen ersten Schaltelements 71 ist dabei der Widerstand zwischen Drain D und Source S des geschlossenen ersten Schaltelements 71. Der zweite Widerstand R2 des geschlossenen zweiten Schaltelements 72 ist dabei der Widerstand zwischen Drain D und Source S des geschlossenen zweiten Schaltelements 72.

Wenn das erste Schaltelement 71 geschlossen und das zweite Schaltelement 72 geöffnet ist, also wenn die Batteriezelle 2 zwischen den ersten Anschluss 51 und den zweiten Anschluss 52 geschaltet ist, so gilt:

$$Id = U1 / R1$$

Wenn das zweite Schaltelement 72 geschlossen und das erste Schaltelement 71 geöffnet ist, also wenn die Batteriezelle 2 in der Zelleinheit 100 überbrückt ist, so gilt:

$$Id = -1 * U2 / R2$$

Die Recheneinheit 80 weist ferner die besagten Mittel zur Messung der ersten Spannung U1 sowie zur Messung der zweiten Spannung U2 auf. Es ist auch denkbar, dass die Mittel zur Messung der ersten Spannung U1 sowie zur Messung der zweiten Spannung U2 separat von der Recheneinheit 80 angeordnet sind. In diesem Fall wird ein Wert der gemessenen Spannung U1, U2 zu der Recheneinheit 80 übertragen, insbesondere als digitaler Wert.

Es ist auch denkbar, dass die genannten Berechnungen nicht in einer Recheneinheit 80 innerhalb der Zelleinheit 100, sondern durch eine andere Recheneinheit beispielsweise auf Batteriemodulebene oder Batteriesystemebene oder ein weiteres Steuergerät außerhalb des Batteriesystems durchgeführt werden. In diesem Fall wird ein Wert der gemessenen Spannung U1, U2 zu einer solchen weiteren Recheneinheit übertragen, insbesondere als digitaler Wert.

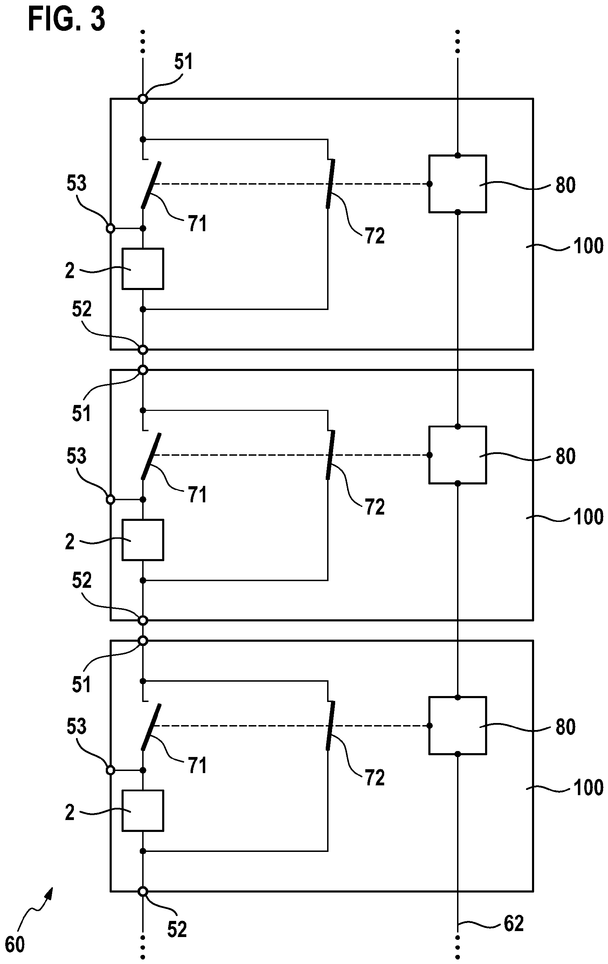

Figur 3 zeigt eine schematische Darstellung eines Versorgungsstrangs 60 mit mehreren in Figur 2 dargestellten Zelleinheiten 100. Die einzelnen Zelleinheiten 100 sind dabei vorliegend in Serie geschaltet, wobei jeweils der erste Anschluss 51 einer Zelleinheit 100 mit dem zweiten Anschluss 52 der benachbarten Zelleinheit 100 verbunden ist.

Wenn die Batteriezelle 2 einer der Zelleinheiten 100 zwischen den ersten Anschluss 51 und den zweiten Anschluss 52 geschaltet ist, so ist die resultierende Spannung des Versorgungsstrangs 60 erhöht. Wenn die Batteriezelle 2 in einer der Zelleinheiten 100 überbrückt ist, so ist die resultierende Spannung des Versorgungsstrangs 60 erniedrigt.

Daneben sind andere Formen der Verschaltung von Zelleinheiten 100 denkbar, beispielsweise in einer Parallelschaltung, wofür jeweils der erste Anschluss 51 einer Zelleinheit 100 mit dem ersten Anschluss 51 der benachbarten Zelleinheit 100 und jeweils der zweite Anschluss 52 einer Zelleinheit 100 mit dem zweiten Anschluss 52 der benachbarten Zelleinheit 100 verbunden sind. Kombinationen dieser Verschaltungen zu gemischten Reihen- / Parallelschaltungen sind ebenso denkbar.

Die Recheneinheiten 80 der einzelnen Zelleinheiten 100 sind dabei über einen Datenbus 62 miteinander sowie mit einer nicht dargestellten übergeordneten Steuereinheit verbunden. Bei dem Datenbus 62 handelt es sich beispielsweise um einen CAN-Bus oder LIN-Bus.

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen.

**Patentansprüche**

1. Zelleinheit (100), umfassend mindestens eine Batteriezelle (2), sowie einen ersten Anschluss (51) und einen zweiten Anschluss (52), mindestens ein erstes als Feldeffekttransistor ausgebildetes Schaltelement (71), welches mit der Batteriezelle (2) in Serie geschaltet ist, und ein zweites als Feldeffekttransistor ausgebildetes Schaltelement (72), wobei der erste Anschluss (51) mit dem ersten Schaltelement (71) und mit dem zweiten Schaltelement (72) verbunden ist, und
der zweite Anschluss (52) mit der Batteriezelle (2) und mit dem zweiten Schaltelement (72) verbunden ist, wobei
ein dritter Anschluss (53) vorgesehen ist,
welcher mit dem ersten Schaltelement (71) und mit der Batteriezelle (2) verbunden ist, **dadurch gekennzeichnet, dass**
Mittel zur Messung einer ersten Spannung (U1) zwischen dem ersten Anschluss (51) und dem dritten Anschluss (53), bei geschlossenem erstem Schaltelement (71) und offenem zweitem Schaltelement (72), welche einer an dem ersten Schaltelement (71) anliegenden Spannung entspricht, und
Mittel zur Messung einer zweiten Spannung (U2) zwischen dem ersten Anschluss (51) und dem zweiten Anschluss (52), bei offenem erstem Schaltelement (71) und geschlossenem zweitem Schaltelement (72), welche einer an dem zweiten Schaltelement (72) anliegenden Spannung entspricht, vorgesehen sind.

2. Zelleinheit (100) nach Anspruch 1, **dadurch gekennzeichnet, dass** eine Recheneinheit (80) vorgesehen ist, welche dazu eingerichtet ist, einen durch die Zelleinheit (100) fließenden Strom (Id) aus der gemessenen Spannung (U1, U2) und einem elektrischen Widerstand (R1, R2) des geschlossenen Schaltelements (71, 72) zu bestimmen.

3. Zelleinheit (100) nach Anspruch 2, **dadurch gekennzeichnet, dass** die Recheneinheit (80) ein Modell (82) zur Bestimmung des elektrischen Widerstands (R1, R2) des geschlossenen Schaltelements (71, 72) unter Berücksichtigung einer an dem Schaltelement (71, 72) anliegenden Steuerspannung und/oder einer Temperatur des Schaltelements (71, 72) und/oder weiterer physikalischer Parameter des Schaltelements (71, 72) umfasst.

4. Verfahren zur Bestimmung eines durch eine Zelleinheit (100) nach einem der vorstehenden Ansprüche fließenden Stromes (Id), wobei eine über einem geschlossenen Schaltelement (71, 72) abfallende Spannung (U1, U2) gemessen wird, und
der Strom (Id) aus der gemessenen Spannung (U1, U2) und einem elektrischen Widerstand (R1, R2) des geschlossenen Schaltelements (71, 72) bestimmt wird.

5. Verfahren nach Anspruch 4, **dadurch gekennzeichnet, dass** der elektrische Widerstand (R1, R2) des geschlossenen Schaltelements (71, 72) unter Berücksichtigung einer an dem Schaltelement (71, 72) anliegenden Steuerspannung und/oder einer Temperatur des Schaltelements (71, 72) und/oder weiterer physikalischer Parameter des Schaltelements (71,72) bestimmt wird.

6. Verfahren nach Anspruch 5, **dadurch gekennzeichnet, dass** der elektrische Widerstand (R1, R2) des geschlossenen Schaltelements (71, 72) und der Strom (Id) in einer Recheneinheit (80) bestimmt werden, welche ein Modell (82) zur Bestimmung des elektrischen Widerstands (R1, R2) des geschlossenen Schaltelements (71, 72) umfasst.

7. Verfahren nach Anspruch 6, **dadurch gekennzeichnet, dass** ein analoger Wert der gemessenen Spannung (U1, U2) in einen digitalen Wert gewandelt wird, welcher zu der Recheneinheit (80) übertragen wird.

8. Verfahren nach einem der Ansprüche 6 bis 7, **dadurch gekennzeichnet, dass** zur Kalibrierung der Recheneinheit (80) ein Kalibrierstrom durch die Zelleinheit (100) geleitet wird, dass der elektrische Widerstand (R1, R2) des geschlossenen Schaltelements (71, 72) und der Strom (Id) bestimmt werden, und dass bei einer Abweichung des bestimmten Stroms (Id) von dem Kalibrierstrom das Modell (82) korrigiert wird.

9. Verfahren nach Anspruch 8, **dadurch gekennzeichnet, dass** der Kalibrierstrom ein Ladestrom der Zelleinheit (100) ist.

10. Verfahren nach einem der Ansprüche 8 oder 9, **dadurch gekennzeichnet, dass** über eine Änderung des elektrischen Widerstands (R1, R2) des Schaltelements (71, 72) eine Alterung des Schaltelements (71, 72) überwacht wird, und dass bei Erkennung eines drohenden Frühausfalls des Schaltelements (71, 72) Sicherheitsmaßnahmen, insbesondere ein Abschalten der Batteriezelle (2) und/oder ein Abschalten eines dem Schaltelement (71, 72) zugeordneten Batteriemoduls und/oder Batteriesystems und/oder ein Austausch des Schaltelements (71, 72), eingeleitet werden.

11. Verwendung der Zelleinheit (100) nach einem der Ansprüche 1 bis 3 und/oder des Verfahrens nach einem der Ansprüche 4 bis 10 in einem Elektrofahrzeug (EV), in einem Hybridfahrzeug (HEV), in einem Plug-In-Hybridfahrzeug (PHEV) oder in einem Consumer-Elektronik-Produkt oder in Energieversorgungseinrichtungen wie Solaranlagen oder stationäre Energiespeichereinrichtungen.

**Claims**

1. Cell unit (100), comprising at least one battery cell (2), and also a first connection (51) and a second connection (52), at least one first switching element (71) which is designed as a field-effect transistor and is connected in series with the battery cell (2), and a second switching element (72) which is designed as a field-effect transistor, wherein

the first connection (51) is connected to the first switching element (71) and to the second switching element (72), and

the second connection (52) is connected to the battery cell (2) and to the second switching element (72), wherein

a third connection (53) is provided,

which third connection is connected to the first switching element (71) and to the battery cell (2), **characterized in that**

means for measuring a first voltage (U1) are provided between the first connection (51) and the third connection (53), with a closed first switching element (71) and an open second switching element (72), which first voltage corresponds to a voltage which is applied to the first switching element (71), and means for measuring a second voltage (U2) are provided between the first connection (51) and the second connection (52), with an open first switching element (71) and a closed second switching element (72), which second voltage corresponds to a voltage which is applied to the second switching element (72).

2. Cell unit (100) according to Claim 1, **characterized in that** a computer unit (80) is provided, which computer unit is designed to determine a current (Id) flowing through the cell unit (100) from the measured voltage (U1, U2) and an electrical resistance (R1, R2) of the closed switching element (71, 72).

3. Cell unit (100) according to Claim 2, **characterized in that** the computer unit (80) comprises a model (82) for determining the electrical resistance (R1, R2) of the closed switching element (71, 72) taking into account a control voltage which is applied to the switching element (71, 72) and/or a temperature of the switching element (71, 72) and/or further physical parameters of the switching element (71, 72).

4. Method for determining a current (Id) flowing through a cell unit (100) according to one of the preceding claims, wherein a voltage (U1, U2) which is dropped across a closed switching element (71, 72) is measured, and the current (Id) is determined from the measured voltage (U1, U2) and an electrical resistance (R1, R2) of the closed switching element (71, 72).

5. Method according to Claim 4, **characterized in that** the electrical resistance (R1, R2) of the closed switching element (71, 72) is determined taking into account a control voltage which is applied to the switching element (71, 72) and/or a temperature of the switching element (71, 72) and/or further physical parameters of the switching element (71, 72).

6. Method according to Claim 5, **characterized in that** the electrical resistance (R1, R2) of the closed switching element (71, 72) and the current (Id) are determined in a computer unit (80) which comprises a model (82) for determining the electrical resistance (R1, R2) of the closed switching element (71, 72).

7. Method according to Claim 6, **characterized in that** an analogue value of the measured voltage (U1, U2) is converted into a digital value which is transmitted to the computer unit (80).

8. Method according to either of Claims 6 and 7, **characterized in that**, for the purpose of calibrating the computer unit (80), a calibration current is conducted through the cell unit (100), **in that** the electrical resistance (R1, R2) of the closed switching element (71, 72) and the current (Id) are determined, and **in that** the model (82) is corrected in the event of a deviation in the determined current (Id) from the calibration current.

9. Method according to Claim 8, **characterized in that** the calibration current is a charging current of the cell unit (100).

10. Method according to either of Claims 8 and 9, **characterized in that** ageing of the switching element (71, 72) is monitored by way of a change in the electrical resistance (R1, R2) of the switching element (71, 72), and **in that** safety measures, in particular disconnection of the battery cell (2) and/or disconnection of a battery module and/or battery system which is associated with the switching element (71, 72) and/or replacement of the switching element (71, 72), are initiated when a threat of early failure of the switching element (71, 72) is identified.

11. Use of the cell unit (100) according to one of Claims 1 to 3 and/or the method according to one of Claims 4 to 10 in an electric vehicle (EV), in a hybrid vehicle (HEV), in a plug-in hybrid vehicle (PHEV) or in a consumer electronics product or in power supply devices such as solar installations or stationary energy storage devices.

**Revendications**

1. Unité de cellule (100), comprenant au moins une cellule de batterie (2), ainsi qu'une première borne (51) et une deuxième borne (52), au moins un premier élément de commutation (71) qui est réalisé sous la forme d'un transistor à effet de champ et qui est monté en série avec la cellule de batterie (2), et un deuxième élément de commutation (72) qui est réalisé sous la forme d'un transistor à effet de champ, dans lequel la première borne (51) est reliée au premier élément de commutation (71) et au deuxième élément de commutation (72), et
la deuxième borne (52) est reliée à la cellule de batterie (2) et au deuxième élément de commutation (72), dans lequel
il est prévu une troisième borne (53) qui est reliée au premier élément de commutation (71) et à la cellule de batterie (2),
**caractérisé en ce qu'**il est prévu
des moyens permettant de mesurer une première tension (U1) entre la première borne (51) et la troisième borne (53), le premier élément de commutation (71) étant fermé et le deuxième élément de commutation (72) étant ouvert, laquelle correspond à une tension appliquée au premier élément de commutation (71), et
des moyens permettant de mesurer une deuxième tension (U2) entre la première borne (51) et la deuxième borne (52), le premier élément de commutation (71) étant ouvert et le deuxième élément de commutation (72) étant fermé, laquelle correspond à une tension appliquée au deuxième élément de commutation (72).

2. Unité de cellule (100) selon la revendication 1, **caractérisée en ce qu'**il est prévu une unité de calcul (80) qui est conçue pour déterminer un courant (Id) s'écoulant à travers l'unité de cellule (100) à partir de la tension mesurée (U1, U2) et d'une résistance électrique (R1, R2) de l'élément de commutation (71, 72) fermé.

3. Unité de cellule (100) selon la revendication 2, **caractérisée en ce que** l'unité de calcul (80) comprend un modèle (82) permettant de déterminer la résistance électrique (R1, R2) de l'élément de commutation (71, 72) fermé en tenant compte d'une tension de commande appliquée à l'élément de commutation (71, 72) et/ou d'une température de l'élément de commutation (71, 72) et/ou d'autres paramètres physiques de l'élément de commutation (71, 72).

4. Procédé de détermination d'un courant (Id) s'écoulant à travers une unité de cellule (100) selon l'une des revendications précédentes, dans lequel une tension (U1, U2) s'abaissant aux bornes d'un élément de commutation (71, 72) fermé est mesurée, et le courant (Id) est déterminé à partir de la tension mesurée (U1, U2) et d'une résistance électrique (R1, R2) de l'élément de commutation (71, 72) fermé.

5. Procédé selon la revendication 4, **caractérisé en ce que** la résistance électrique (R1, R2) de l'élément de commutation (71, 72) fermé est déterminée en tenant compte d'une tension de commande appliquée à l'élément de commutation (71, 72) et/ou d'une température de l'élément de commutation (71, 72) et/ou d'autres paramètres physiques de l'élément de commutation (71, 72).

6. Procédé selon la revendication 5, **caractérisé en ce que** la résistance électrique (R1, R2) de l'élément de commutation (71, 72) fermé et le courant (Id) sont déterminés dans une unité de calcul (80) qui comprend un modèle (82) permettant de déterminer la résistance électrique (R1, R2) de l'élément de commutation (71, 72) fermé.

7. Procédé selon la revendication 6, **caractérisé en ce qu'**une valeur analogique de la tension (U1, U2) mesurée est convertie en une valeur numérique qui est transmise à l'unité de calcul (80).

8. Procédé selon l'une des revendications 6 à 7, **caractérisé en ce qu'**un courant d'étalonnage est amené à s'écouler à travers l'unité de cellule (100) pour étalonner l'unité de calcul (80), **en ce que** la résistance électrique (R1, R2) de l'élément de commutation (71, 72) fermé et le courant (Id) sont déterminés, et **en ce que** le modèle (82) est corrigé lorsque le courant (Id) déterminé s'écarte du courant d'étalonnage.

9. Procédé selon la revendication 8, **caractérisé en ce que** le courant d'étalonnage est un courant de charge de l'unité de cellule (100).

10. Procédé selon l'une des revendications 8 ou 9, **caractérisé en ce qu'**un vieillissement de l'élément de commutation (71, 72) est surveillé par une modification de la résistance électrique (R1, R2) de l'élément de commutation (71, 72), et **en ce que**, lorsqu'une défaillance précoce imminente de l'élément de commutation (71, 72) est détectée, des mesures de sécurité, en particulier une mise hors tension de la cellule de batterie (2) et/ou une mise hors tension d'un module de batterie et/ou d'un système de batterie associé à l'élément de commutation (71, 72) et/ou un échange de l'élément de commutation (71, 72), sont déclenchées.

11. Utilisation de l'unité de cellule (100) selon l'une des revendications 1 à 3 et/ou du procédé selon l'une des revendications 4 à 10 dans un véhicule électrique (EV), dans un véhicule hybride (HEV), dans un véhicule hybride rechargeable (PHEV) ou dans un produit électronique grand public ou dans des dispositifs d'alimentation en énergie tels que des installations solaires ou des dispositifs accumulateurs d'énergie fixes.

# FIG. 1

# FIG. 2

# FIG. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2014086696 A2
- DE 102010027857 A1
- DE 102010027861 A1
- US 20080278116 A1
- JP 2001339869 A
- WO 2012123895 A1
- EP 2669988 A1
- DE 102012214956 A1